(19) Europäisches Patentamt
European Patent Office
Office européen des brevets

(11) **EP 2 603 972 B1**

(12) **EUROPÄISCHE PATENTSCHRIFT**

(45) Veröffentlichungstag und Bekanntmachung des Hinweises auf die Patenterteilung:
**07.11.2018 Patentblatt 2018/45**

(51) Int Cl.:
*H04B 1/04* *(2006.01)*        *H03B 19/16* *(2006.01)*
*G01S 7/03* *(2006.01)*        *G01S 13/58* *(2006.01)*

(21) Anmeldenummer: **11754861.0**

(22) Anmeldetag: **01.09.2011**

(86) Internationale Anmeldenummer:
**PCT/EP2011/065129**

(87) Internationale Veröffentlichungsnummer:
**WO 2012/038236 (29.03.2012 Gazette 2012/13)**

(54) **VERFAHREN UND VORRICHTUNG ZUR VERARBEITUNG VON SIGNALEN BASIEREND AUF EINEM TRANSMISSIONSMISCHER, FREQUENZVERVIELFACHUNG UND SUBHARMONISCHER MISCHUNG**

METHOD AND DEVICE FOR PROCESSING SIGNALS ON THE BASIS OF A TRANSMISSION MIXER, FREQUENCY MULTIPLIER, AND SUBHARMONIC MIXING

PROCÉDÉ ET DISPOSITIF DE TRAITEMENT DE SIGNAUX SUR LA BASE D'UN MÉLANGEUR DE TRANSMISSION, MULTIPLICATION DE FRÉQUENCE ET MÉLANGE SUBHARMONIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.09.2010 DE 102010041372**

(43) Veröffentlichungstag der Anmeldung:
**19.06.2013 Patentblatt 2013/25**

(73) Patentinhaber: **Siemens Aktiengesellschaft**
**80333 München (DE)**

(72) Erfinder:
• **ZIROFF, Andreas**
  **80469 München (DE)**
• **ZANATI, Abdellatif**
  **81739 München (DE)**

(56) Entgegenhaltungen:
DE-A1-102004 048 994     US-A- 3 076 133
US-A- 4 749 949           US-A- 5 495 255
US-A- 5 596 325           US-A- 5 924 021
US-A1- 2003 094 976

**Beschreibung**

Die Erfindung betrifft ein Verfahren und eine Vorrichtung zur Verarbeitung von Signalen.

US 4,749,949 betrifft einen selbst-vorverzerrenden Mikrowellen-Frequenz-Multiplizierer mittels Dioden.

US 3,076,133 A betrifft einen parametrischen Frequenzmultiplizierer zur Erzeugung von Signalen einer gewünschten ungeraden harmonischen Frequenz eines Eingangssignals.

US 2003/0094976 A1 betrifft eine Mixer-Schaltung, einen Empfänger sowie eine Frequenzvergleichsschaltung.

DE 10 2004 048 994 A1 betrifft die Bestimmung von Laufzeiten zwischen einem Sende- und einem Empfangssignal.

US 5,495,255 betrifft ein FM Radarsystem geringer Abmessung, das insbesondere zur Kollisionsvermeidung eingesetzt werden kann.

US 5,924,021 betrifft ein Frequenzumwandlungsschaltung und ein Verfahren für ein Millimeterwellenradio.

Zum Erzeugen und Empfangen hochfrequenter Signale wird überwiegend eines der folgenden Systeme verwendet:

Ein System mit separatem Sende- und Empfangszweig erzeugt und moduliert mittels des Sendezweigs die hochfrequenten Signale und verstärkt, filtert, mischt, demoduliert anhand eines separat ausgeführten Empfangszweigs empfangene Signale. Sende- und Empfangszweig können mit unterschiedlichen Antennen ausgestattet sein oder über einen Sende-/Empfangskoppler eine gemeinsame Antenne nutzen. Ein derartiges System ist häufig überaus komplex und benötigt zur Umsetzung eine Vielzahl von Bauelementen. Beispielsweise werden bei der Erzeugung und bei dem Empfang hoher Frequenzen aufwändig zu montierende Bauteile benötigt, die vorzugsweise in einer sogenannten Chip&Wire-Aufbautechnik verbunden sind.

Ein weiteres System nutzt einen Transmissionsmischer, der ein gleichzeitiges Senden und Empfangen hochfrequenter Signale ermöglicht. Dabei dient das Sendesignal auch als lokales Oszillatorsignal für die Abwärtsumsetzung des empfangenen Signals.

Es von Nachteil, dass sich mit bestehenden Systemen ein hochfrequentes Signal nur mit erheblichem Aufwand erzeugen und verarbeiten lässt.

Die Aufgabe der Erfindung besteht darin, den vorstehend genannten Nachteil zu vermeiden und insbesondere eine Lösung anzugeben, die ein einfaches und kostengünstiges System zur Erzeugung und zum Empfang hochfrequenter Signale ermöglicht.

Diese Aufgabe wird gemäß den Merkmalen der unabhängigen Patentansprüche gelöst. Weiterbildungen der Erfindung ergeben sich auch aus den abhängigen Ansprüchen.

Zur Lösung der Aufgabe wird ein Verfahren zur Verarbeitung von Signalen vorgeschlagen gemäß den Merkmalen des Anspruchs 1.

Die erste und zweite Komponente nehmen unterschiedliche Funktionen wahr, können aber getrennt oder gemeinsam in einer physikalischen Einheit zusammengefasst sein.

Hierbei ist es von Vorteil, dass die erste Komponente unter anderem die Funktionalität der Weiterleitung des Eingangssignals bereitstellt und die zweite Komponente die Frequenz des weitergeleiteten Signals auf effiziente Art und Weise vervielfacht. Etwaige Dämpfungsverluste der ersten Komponente können z.B. ausgeglichen werden dadurch, dass das Eingangssignal eine ausreichend hohe Signalstärke aufweist. Der Ansatz erlaubt z.B. eine Verdreifachung oder eine Verfünffachung der Frequenz des Eingangssignals. Die Bereitstellung des Eingangssignals und (siehe unten) Verarbeitung des von der zweiten Komponente bereitgestellten empfangenen Signals kann somit in einem deutlich niedrigeren Frequenzbereich erfolgen.

Erfindungswesentlich ist es, dass die erste Komponente ein Transmissionsmischer ist.
Der Transmissionsmischer leitet (transmittiert) das Eingangssignal an die zweite Komponente und verfügt vorzugsweise in der Gegenrichtung, also für Signale die von der zweiten Komponente bereitgestellt werden, über eine Abwärts-Umwandlungs- bzw. Abwärts-Misch-Funktionalität.

Erfindungswesentlich ist es,

- dass das von der zweiten Komponente bereitgestellte, frequenz-vervielfachte Signal über eine Antenne emittiert wird,
- bei dem mittels der Antenne ein Signal empfangen wird und das empfangene Signal von der zweiten Komponente subharmonisch gemischt und an die erste Komponente weitergeleitet wird.

Somit stellt die zweite Komponente in einer Richtung eine Frequenz-Vervielfachungs-Funktionalität bereit. In die Gegenrichtung stellt die zweite Komponente eine subharmonische Misch-Funktionalität bereit. Damit können von der zweiten Komponente empfangene Signale in einen Frequenzbereich transformiert werden, der deutlich unterhalb der Frequenz des von der Antenne emittierten Signals liegt. Damit vereinfacht sich die (Weiter-)Verarbeitung des empfangenen Signals deutlich. Insbesondere ist es eine Weiterbildung, dass das empfangene Signal von der zweiten Komponente subharmonisch gemischt wird und ein Signal mit der Frequenz

$$f_2 - 2\,f_1$$

an die erste Komponente weitergeleitet wird, wobei

$f_2$    die Frequenz des von der zweiten Komponente

empfangenen Signals und

$f_1$     die Frequenz des der zweiten Komponente bereitgestellten Signals ist.

Auch ist es eine Weiterbildung, dass das von der zweiten Komponente erhaltene Signal von der ersten Komponente abwärtsgemischt wird.

Ferner ist es erfindungswesentlich, dass von der ersten Komponente nach der Abwärtsmischung ein Signal mit der Frequenz

$$f_3 - f_1$$

bereitgestellt wird, wobei

$f_1$     die Frequenz des Eingangssignals bzw. die Frequenz des der zweiten Komponente bereitgestellten Signals und

$f_3$     die Frequenz des Signals, das von der zweiten Komponente subharmonisch gemischt und an die erste Komponente weitergeleitet wurde,

bezeichnen.

Im Rahmen einer zusätzlichen Weiterbildung wird das abwärtsgemischte Signal verarbeitet und anhand des abwärtsgemischten Signals kann eine in dem empfangenen Signal enthaltene Information detektiert werden.

Eine nächste Weiterbildung besteht darin, dass die Frequenz des von der ersten Komponente erhaltenen Signals mittels der zweiten Komponente gemäß einem Faktor

$$2n-1, \qquad n = 1, 2, 3,\dots$$

vervielfacht wird.

Die oben genannte Aufgabe wird auch gelöst mittels einer Vorrichtung zur Verarbeitung von Signalen gemäß den Merkmalen des Anspruchs 5.

Insbesondere handelt es sich bei der ersten Komponente um einen Transmissionsmischer.

Hierbei sei angemerkt, dass insbesondere die vorstehenden Ausführungen für diese Vorrichtung entsprechend gelten bzw. die nachfolgenden Ausführungen auch auf das erläuterte Verfahren anwendbar sind.

Eine Ausgestaltung ist es, dass die Vorrichtung in Verbindung mit Doppler- oder Radarsensoren anwendbar ist.

Insbesondere kann die vorgeschlagene Lösung eingesetzt werden, um Informationen betreffend in einer Abstrahlrichtung angeordnete Objekte zu bestimmen, z.B. Entfernung, Geschwindigkeit, etc.

Auch ist es möglich, die hier vorgestellte Lösung zur Kommunikation bzw. zum Datenaustausch zwischen gleichartigen Systemen zu nutzen. Beispielsweise kann eine Punkt-zu-Punkt oder eine Punkt-zu-Mehrpunkt Kommunikationsverbindung unter Nutzung des beschriebenen Ansatzes bereitgestellt werden.

Eine Ausführungsform besteht darin, dass das Bauteil mit der nichtlinearen Kennlinie zwei antiparallel geschaltete Dioden umfasst.

Eine nächste Ausgestaltung ist es, dass die Dioden Kapazitätsdioden oder Schottky-Dioden sind.

Auch ist es eine Ausgestaltung, dass die erste Komponente und/oder die zweite Komponente in Leiterplattentechnologie, in Dünnfilm-Technologie, in Dickfilm-Technologie oder als integrierte Schaltung ausgeführt ist.

Eine Weiterbildung besteht darin, dass die zweite Komponente mindestens ein Filter, insbesondere mindestens ein Hochpassfilter und mindestens ein Tiefpassfilter aufweist.

Eine zusätzliche Ausgestaltung ist es, dass das mindestens eine nichtlineare Bauteil der zweiten Komponente über das Tiefpassfilter mit der ersten Komponente verbunden ist und bei dem das mindestens eine nichtlineare Bauteil über das Hochpassfilter direkt oder indirekt mit einer Antenne verbunden ist.

Weiterhin wird ein Kommunikationssystem oder ein Radarsystem vorgeschlagen umfassend mindestens eine der hier beschriebenen Vorrichtungen.

Ausführungsbeispiele der Erfindung werden nachfolgend anhand der Zeichnungen dargestellt und erläutert.

Es zeigen:

Fig.1     eine schematische Darstellung eines transmittierenden Mischers;

Fig.2     einen schematischen Aufbau einer zweiten Komponente umfassend ein Filter, ein antiparallel geschaltetes Diodenpaar mit kubischer Strom-/Spannungskennlinie und ein weiteres Filter;

Fig.3     eine Zusammenschaltung der ersten Komponente und der zweiten Komponente.

Es wird ein Konzept vorgeschlagen, das sich einfach realisieren lässt und geringe Kosten betreffend die beteiligten Fertigungsschritte ermöglicht.

Insbesondere werden hierzu eine erste Komponente und eine zweite Komponente miteinander verbunden.

Bei der ersten Komponente handelt es sich um einen transmittierenden Mischer. Der transmittierende Mischer kann als Aufwärts- oder als Abwärts-Umsetzer betrieben werden. Für die vorliegende Lösung wird der transmittierende Mischer vorzugsweise als Abwärts-Umsetzer eingesetzt.

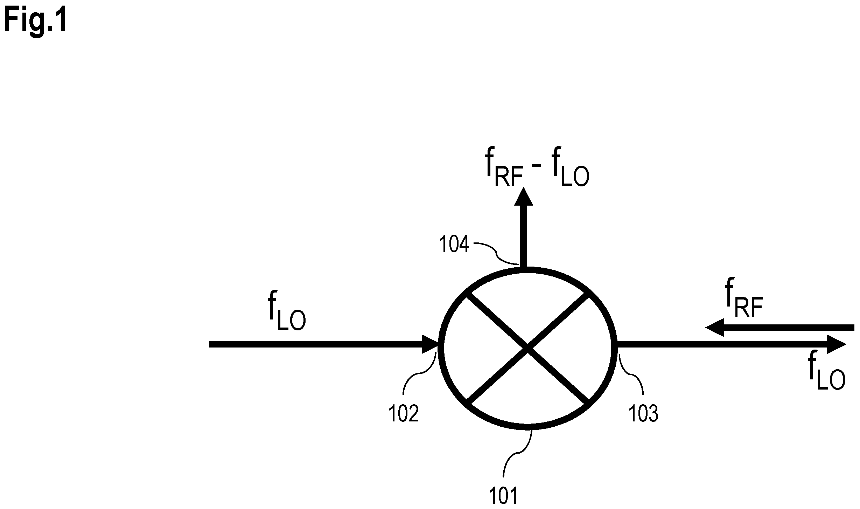

Fig.1 zeigt einen transmittierenden Mischer 101 mit einem Anschluss 102 und einem Anschluss 103. An dem Anschluss 102 liegt ein Signal mit einer Frequenz

$f_{LO}$ (dabei handelt es sich z.B. um eine Frequenz, die auch von einem lokalen Oszillator verwendet werden kann) an, das über den transmittierenden Mischer 101 an dem Anschluss 103 ausgegeben wird. Beispielsweise wird ein reflektiertes Signal mit einer Frequenz $f_{RF}$ an dem Anschluss 103 empfangen. Der transmittierende Mischer 101 stellt an einem Ausgang 104 ein Differenzsignal mit der Frequenz $f_{RF}-f_{LO}$ bereit.

Ergänzend sei erwähnt, dass der transmittierende Mischer 101 verlustbehaftet sein kann, d.h. das das Signal, das an dem Anschluss 103 den transmittierenden Mischer 101 verlässt, gegenüber dem Signal, das an den Anschluss 102 angelegt wird, gedämpft sein kann.

Die zweite Komponente kann einerseits als ein Frequenzvervielfacher, z.B. als ein Frequenzverdreifacher, und andererseits als ein subharmonischer Mischer betrieben werden.

Die zweite Komponente kann beispielsweise ein antiparallel geschaltetes Diodenpaar aufweisen, das eine kubische Strom-/Spannungskennlinie aufweist. Eine solche Kennlinie kann effizient dazu eingesetzt werden, um aus einem sinusförmigen Signal mit einer Frequenz f ein (sinusförmiges) Signal mit einer Frequenz 3f zu erzeugen.

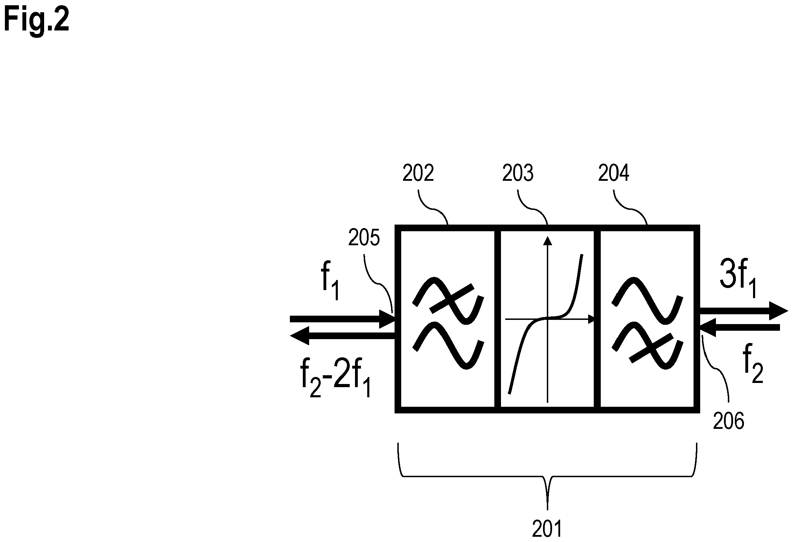

Fig.2 zeigt einen schematischen Aufbau einer solchen zweiten Komponente 201 umfassend ein Filter 202, ein antiparallel geschaltetes Diodenpaar 203 mit kubischer Strom-/Spannungskennlinie und ein Filter 204. Das Filter 202 ist über die antiparallel geschalteten Dioden 203 mit dem Filter 204 verbunden. Die zweite Komponente 201 weist an dem Filter 202 einen Anschluss 205 und an dem Filter 204 einen Anschluss 206 auf.

Weiterhin ist die zweite Komponente 201 so ausgelegt, dass sie auch als (subharmonischer) Mischer wirkt. Dazu wird an den Anschluss 205 ein Signal mit hoher Leistung und einer Frequenz $f_1$ und an den Anschluss 206 ein Signal mit einer Frequenz $f_2 \sim 3f_1$ angelegt. Die kubische Kennlinie des antiparallelen Diodenpaars 203 bewirkt die Erzeugung von Frequenzanteilen mit der Frequenz $f_{intern} = f_2 - 2 f_1$. Bei geeigneter Wahl der beteiligten Filter 202, 204 kann dieses Signal ungehindert an dem Anschluss 205 austreten.

Allgemein kann die zweite Komponente in Richtung von dem Anschluss 206 zu dem Anschluss 205 so ausgelegt sein, dass an dem Anschluss 205 ein Signal bereitgestellt wird, das insbesondere die Differenzfrequenz aus $f_2$ und 2-mal der Frequenz $f_1$ aufweist.

Vorzugsweise ist das Filter 202 als ein Tiefpassfilter und das Filter 204 als ein Hochpassfilter ausgeführt.

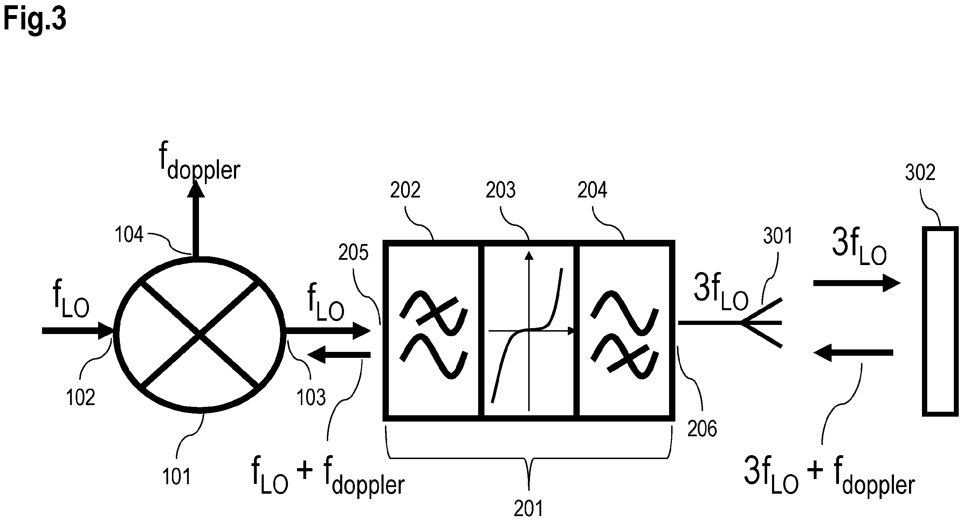

Fig.3 zeigt eine Zusammenschaltung der ersten Komponente 101 und der zweiten Komponente 201. Eine derartige Kombination kann z.B. in einem Dopplerradar eingesetzt werden.

Ein Signal mit einer Frequenz $f_{LO}$ wird an den Anschluss 102 des transmittierenden Mischers 101 angelegt, passiert mit geringer Abschwächung den transmittierenden Mischer 101 und gelangt zu dem Anschluss 205 der zweiten Komponente 201. Die zweite Komponente 201 verdreifacht die Frequenz dieses Signals und stellt somit an dem Anschluss 206 ein Signal mit der Frequenz $3f_{LO}$ bereit, das über eine mit dem Anschluss 206 verbundene Antenne 301 emittiert wird. Das so emittierte Signal trifft auf ein Objekt 302, wobei ein Teil des emittierten Signals mit der Frequenz $3f_{LO} + f_{doppler}$ reflektiert, von der Antenne 301 detektiert und an den Anschluss 206 der zweiten Komponente 201 weitergeleitet wird. Dieses Signal wird in der zweiten Komponente 201 subharmonisch gemischt und in ein Signal mit der Frequenz $f_{LO} + f_{doppler}$ umgesetzt, das über den Anschluss 205 an den transmittierenden Mischer 101 weitergeleitet wird. Der transmittierende Mischer 101 stellt an seinem Ausgang 104 nach einer Frequenzumsetzung ein Signal mit der Frequenz $f_{doppler}$ bereit. Anhand dieser Frequenz $f_{doppler}$ kann z.B. die Geschwindigkeit des Objektes 302 bestimmt werden.

Vorzugsweise weist das Signal mit der Frequenz $f_{LO}$, das an dem Eingang 102 bereitgestellt wird, eine ausreichend hohe Leistung auf, so dass trotz einer Dämpfung durch die erste Komponente 101 die zweite Komponente 201 in ihrem Arbeitspunkt betrieben werden kann.

Die vorgeschlagene Lösung kann beispielsweise eingesetzt werden in Verbindung mit Doppler- oder FMCW-Radarsensoren (FMCW = Frequency Modulated Continuous Wave, frequenzmoduliertes Dauerstrichradar), bei denen gleichzeitig ein Signal ausgesendet und empfangen werden soll. Insbesondere eignet sich der Ansatz dafür, Radarsensoren bei sehr hohen Frequenzen einzusetzen, da gerade bei hohen Frequenzen eine Erzeugung und Verstärkung von Frequenzen sehr viel schwieriger zu beherrschen ist, als bei niedrigen Frequenzen. So verlagert die vorgestellte Lösung vorteilhaft die Frequenzerzeugung auf ein Drittel der tatsächlichen Sendefrequenz. Auch der Empfang der Signale vereinfacht sich entsprechend, da kein Verstärker in dem Empfangspfad benötigt wird.

Besonders vorteilhaft lässt sich die Schaltung einsetzen, wenn die Sendefrequenz f des Radars so gewählt wird, dass die Erzeugung von der Frequenz f/3 mit hinreichend hoher Leistung gut beherrscht bzw. kostengünstig erreicht werden kann.

Weiterhin kann die vorgestellte Lösung in Kommunikationssystemen, sowie zur Abstandsmessung zwischen zwei gleichartigen Systemen eingesetzt werden.

Die Kombination aus erster und zweiter Komponente, insbesondere die zweite Komponente kann in Leiterplattentechnologie oder alternativen Aufbautechniken, z.B. Dünnfilm, Dickschicht oder auch als integrierte Schaltung ausgeführt sein oder hergestellt werden.

Die Filter der zweiten Komponente können vorzugsweise so ausgelegt sein, dass diese als Anpassungselement(e) fungieren. Weiterhin können die Filter so ausgelegt sein, dass unerwünschte Mischprodukte (Frequenzen) unterdrückt werden. Dies könnte beispielsweise eine Funkzulassung entsprechender Systeme vereinfachen.

Beispielhaft ist vorstehend die antiparallele Anordnung zweier Dioden zur Bereitstellung der kubischen Strom-/Spannungskennlinie angeführt. Alternativ kann auch ein anderes nichtlineares Bauteil anstelle der Diode(n) eingesetzt werden. Beispielsweise können Varistoren oder Kapazitätsdioden (Varaktoren, Abstimmdioden) eingesetzt werden. Auch ist es möglich, dass Schottky-Dioden (z.B. Flip-Chip Schottky-Dioden) verwendet werden. Ferner sind Kombinationen aus den hier genannten Bauteilen möglich.

Neben der Auslegung der zweiten Komponente als Frequenzverdreifacher kann diese mit geeigneten nichtlinearen Bauelementen auch als Frequenzverfünffacher dimensioniert werden. In diesem Fall wird nicht der Koeffizient des kubischen Terms $x^3$ der Taylorreihe der eingesetzten Nichtlinearität, sondern der Koeffizient des Terms $x^5$ genutzt. Die verwendete Zwischenfrequenz kann immer noch in dem Bereich der Eingangsfrequenz liegen. Entsprechendes gilt für Systeme mit einem Vervielfachungsfaktor von 2n-1 (mit n=1,2,...).

**Patentansprüche**

1. Verfahren zur Verarbeitung von Signalen,

    - bei dem ein Eingangssignal ($f_{LO}$), das an einer ersten Komponente anliegt, von dieser ersten Komponente (101) zu einer zweiten Komponente (201), die als ein Frequenzvervielfältiger und als ein subharmonischer Mischer betrieben werden kann, geleitet wird;
    - bei dem die zweite Komponente (201) mittels mindestens eines Bauteils mit einer nichtlinearen Kennlinie (203) die Frequenz des erhaltenen Signals vervielfacht ($3f_{LO}$);
    - bei dem die erste Komponente (101) ein Transmissionsmischer ist, der das Eingangssignal an die zweite Komponente weiterleitet und in der Gegenrichtung, in der Signale von der zweiten Komponente bereitgestellt werden, über eine Abwärts-Misch-Funktionalität verfügt,
    - bei dem das von der zweiten Komponente (201) bereitgestellte, frequenz-vervielfachte Signal ($3f_{LO}$) über eine Antenne (301) emittiert wird,
    - bei dem mittels der Antenne (301) ein Signal ($3f_{LO}+f_{doppler}$) empfangen wird und das empfangene Signal von der zweiten Komponente (201) subharmonisch gemischt ($f_{LO}+f_{doppler}$) und an die erste Komponente (101) weitergeleitet wird,
    - bei dem das von der zweiten Komponente an die erste Komponente weitergeleitete Signal von der ersten Komponente abwärtsgemischt wird,
    - bei dem von der ersten Komponente nach der Abwärtsmischung ein Signal mit der Frequenz

$$f3 - f1$$

bereitgestellt wird, wobei

    $f_1$ die Frequenz ($f_{LO}$) des Eingangssignals bzw. die Frequenz ($f_{LO}$) des der zweiten Komponente von der ersten Komponente bereitgestellten Signals und
    $f_3$ die Frequenz des Signals, das von der zweiten Komponente subharmonisch gemischt und an die erste Komponente weitergeleitet wurde,

    bezeichnen.

2. Verfahren nach Anspruch 1, bei dem das empfangene Signal von der zweiten Komponente subharmonisch gemischt wird und ein Signal mit der Frequenz

$$f_2 - 2 f_1$$

an die erste Komponente weitergeleitet wird, wobei

    f2 die Frequenz des empfangenen Signals ist.

3. Verfahren nach einem der vorhergehenden Ansprüche, bei dem das abwärtsgemischte Signal verarbeitet wird und anhand des abwärtsgemischten Signals eine in dem empfangenen Signal enthaltene Information detektiert wird.

4. Verfahren nach einem der vorhergehenden Ansprüche, bei dem die Frequenz des von der ersten Komponente erhaltenen Signals mittels der zweiten Komponente gemäß einem Faktor

$$2n-1, \qquad n = 2, 3,\ldots$$

vervielfacht wird.

5. Vorrichtung zur Verarbeitung von Signalen

    - umfassend eine erste Komponente (101), an der ein Eingangssignal ($f_{LO}$) anliegt und die mit einer zweiten Komponente (201) verbunden ist, die als ein Frequenzvervielfältiger und als ein subharmonischer Mischer betrieben werden kann, wobei das Eingangssignal ($f_{LO}$) von der ersten Komponente an die zweite Komponente geleitet wird,
    - wobei die zweite Komponente (201) mindestens ein Bauteil mit einer nichtlinearen Kennlinie (203) aufweist, anhand dessen die Frequenz eines von der ersten Komponente erhaltenen Signals vervielfachbar ist,
- wobei die erste Komponente (101) ein Transmissionsmischer ist, der das Eingangssignal an die zweite Komponente weiterleitet und in der Gegenrichtung, in der Signale von der zweiten Komponente bereitgestellt werden, über eine Abwärts-Misch-Funktionalität verfügt,
- wobei das von der zweiten Komponente (201) bereitgestellte, frequenz-vervielfachte Signal ($3f_{LO}$) über eine Antenne (301) emittiert wird,
- wobei mittels der Antenne (301) ein Signal ($3f_{LO}+f_{doppler}$) empfangen wird und das empfangene Signal von der zweiten Komponente (201) subharmonisch gemischt ($f_{LO}+f_{doppler}$) und an die erste Komponente (101) weitergeleitet wird,
- wobei das von der zweiten Komponente an die erste Komponente weitergeleitete Signal von der ersten Komponente abwärtsgemischt wird,
- wobei von der ersten Komponente nach der Abwärtsmischung ein Signal mit der Frequenz

$$f3 - f1$$

bereitgestellt wird, wobei

$f_1$ die Frequenz ($f_{LO}$) des Eingangssignals bzw. die Frequenz ($f_{LO}$) des der zweiten Komponente von der ersten Komponente bereitgestellten Signals und
$f_3$ die Frequenz des Signals, das von der zweiten Komponente subharmonisch gemischt und an die erste Komponente weitergeleitet wurde,

bezeichnen.

6. Vorrichtung nach Anspruch 5 zur Verwendung in Verbindung mit Doppler- oder Radarsensoren.

7. Vorrichtung nach einem der Ansprüche 5 oder 6, bei der das Bauteil mit der nichtlinearen Kennlinie (203) zwei antiparallel geschaltete Dioden umfasst.

8. Vorrichtung nach Anspruch 7, bei dem die Dioden Kapazitätsdioden oder Schottky-Dioden sind.

9. Vorrichtung nach einem der Ansprüche 5 bis 8, bei der die erste Komponente und/oder die zweite Komponente in Leiterplattentechnologie, in Dünnfilm-Technologie, in Dickfilm-Technologie oder als integrierte Schaltung ausgeführt ist.

10. Vorrichtung nach einem der Ansprüche 5 bis 9, bei der die zweite Komponente mindestens ein Filter, insbesondere mindestens ein Hochpassfilter und mindestens ein Tiefpassfilter aufweist.

11. Vorrichtung nach Anspruch 10, bei der das mindestens eine nichtlineare Bauteil (203) der zweiten Komponente (201) über das Tiefpassfilter (202) mit der ersten Komponente (101) verbunden ist und bei dem das mindestens eine nichtlineare Bauteil (203) über das Hochpassfilter (204) direkt oder indirekt mit einer Antenne (301) verbunden ist.

**Claims**

1. Method for processing signals,

- wherein an input signal ($f_{LO}$), which exists at a first component, is routed from this first component (101) to a second component (201), which can be operated as a frequency multiplier and as a subharmonic mixer;
- wherein the second component (201) multiplies the frequency of the received signal ($3f_{LO}$) by means of at least one component part with a non-linear characteristic curve (203) ;
- wherein the first component (101) is a transmission mixer which forwards the input signal to the second component and in the opposite direction, in which signals are provided by the second component, has a step-down mixing functionality,
- wherein the frequency-multiplied signal ($3f_{LO}$) provided by the second component (201) is emitted via an antenna (301),
- wherein a signal ($3f_{LO}+f_{doppler}$) is received by means of the antenna (301), and the received signal is subharmonically mixed ($f_{LO}+f_{doppler}$) by the second component (201) and forwarded to the first component (101),
- wherein the signal forwarded from the second component to the first component is step-down mixed by the first component,
- wherein after the step-down mixing, a signal with the frequency

$$f_3 - f_i$$

is provided by the first component wherein

$f_1$ designates the frequency ($f_{LO}$) of the input signal or, respectively, the frequency ($f_{LO}$) of the signal provided to the second component by the first component, and
$f_3$ designates the frequency of the signal which was subharmonically mixed by the second component and forwarded to the first component.

**2.** Method according to claim 1, wherein the received signal is subharmonically mixed by the second component and a signal with the frequency

$$f_2 - 2 f_i$$

is forwarded to the first component, wherein f2 is the frequency of the received signal.

**3.** Method according to one of the preceding claims, wherein the step-down mixed signal is processed and, on the basis of the step-down mixed signal, an item of information contained in the received signal is detected.

**4.** Method according to one of the preceding claims, wherein the frequency of the signal received by the first component is multiplied by means of the second component according to a factor

$$2n-1, \qquad n = 2, 3, \ldots$$

**5.** Device for processing signals

- comprising a first component (101), at which an input signal ($f_{LO}$) exists and which is connected to a second component (201), which can be operated as a frequency multiplier and as a subharmonic mixer, wherein the input signal ($f_{LO}$) is routed from the first component to the second component,
- wherein the second component (201) has at least one component part with a non-linear characteristic curve (203), on the basis of which the frequency of a signal received by the first component can be multiplied,
- wherein the first component (101) is a transmission mixer, which forwards the input signal to the second component and in the opposite direction, in which signals are provided by the second component, has a step-down mixing functionality,
- wherein the frequency-multiplied signal ($3f_{LO}$) provided by the second component (201) is emitted by way of an antenna (301),
- wherein a signal ($3f_{LO}+f_{doppler}$) is received by means of the antenna (301) and the received signal is mixed subharmonically ($f_{LO}+f_{doppler}$) by the second component (201) and forwarded to the first component (101),
- wherein the signal forwarded from the second component to the first component is step-down mixed by the first component,
- wherein after the step-down mixing a signal with the

frequency

$$f_3 - f_i$$

is provided by the first component wherein

$f_1$ designates the frequency ($f_{LO}$) of the input signal or, respectively, the frequency ($f_{LO}$) of the signal provided to the second component by the first component, and
$f_3$ designates the frequency of the signal which was subharmonically mixed by the second component and forwarded to the first component.

**6.** Device according to claim 5 for use in conjunction with Doppler or radar sensors.

**7.** Device according to one of claims 5 or 6, wherein the component part with the non-linear characteristic curve (203) comprises two anti-parallel connected diodes.

**8.** Device according to claim 7, wherein the diodes are tuning diodes or Schottky diodes.

**9.** Device according to one of claims 5 to 8, wherein the first component and/or the second component is designed in PCB technology, thin-film technology, thick-film technology or as an integrated circuit.

**10.** Device according to one of claims 5 to 9, wherein the second component has at least one filter, in particular at least one high-pass filter and at least one low-pass filter.

**11.** Device according to claim 10, wherein the at least one non-linear component part (203) of the second component (201) is connected via the low-pass filter (202) to the first component (101), and wherein the at least one non-linear component part (203) is connected via the high-pass filter (204) directly or indirectly to an antenna (301).

**Revendications**

**1.** Procédé de traitement de signaux,

- dans lequel un signal d'entrée ($f_{LO}$) appliqué à un premier composant est acheminé de ce premier composant (101) vers un deuxième composant (201) qui peut fonctionner comme multiplicateur de fréquence et comme mélangeur subharmonique ;
- dans lequel le deuxième composant (201) multiplie ($3f_{LO}$) la fréquence du signal reçu au moyen d'au moins un élément avec une courbe caractéristique non linéaire (203) ;

- dans lequel le premier composant (101) est un mélangeur de transmission qui retransmet le signal d'entrée au deuxième composant et dispose d'une fonctionnalité de mélange aval dans le sens inverse dans lequel des signaux sont fournis par le deuxième composant ;

- dans lequel le signal ($3f_{LO}$) multiplié en fréquence et fourni par le deuxième composant (201) est émis via une antenne (301) ;

- dans lequel un signal ($3f_{LO+doppler}$) est reçu au moyen de l'antenne (301) et le signal reçu subit un mélange subharmonique ($f_{LO+doppler}$) par le deuxième composant (201) et est retransmis au premier composant (101) ;

- dans lequel le signal retransmis du deuxième composant au premier composant subit un mélange aval par le premier composant ;

- dans lequel un signal de fréquence $f_3$ - $f_1$ est fourni par le premier composant après le mélange aval,

f1 étant la fréquence ($f_{LO}$) du signal d'entrée resp. la fréquence ($f_{LO}$) du signal fourni au deuxième composant par le premier composant et

f3 étant la fréquence du signal qui a subi un mélange subharmonique par le deuxième composant et a été retransmis au premier composant.

2. Procédé selon la revendication 1, dans lequel le signal reçu subit un mélange subharmonique par le deuxième composant et un signal de fréquence $F_2$ - $2f_1$ est retransmis au premier composant, $f_2$ étant la fréquence du signal reçu.

3. Procédé selon l'une des revendications précédentes, dans lequel est traité le signal ayant subi un mélange aval et une information contenue dans le signal reçu est détectée à l'aide du signal ayant subi un mélange aval.

4. Procédé selon l'une des revendications précédentes, dans lequel la fréquence du signal reçu du premier composant est multipliée au moyen du deuxième composant selon un facteur 2n-1, n = 2, 3, ....

5. Dispositif de traitement de signaux comprenant un premier composant (101) auquel est appliqué un signal d'entrée ($f_{LO}$) et qui est relié à un deuxième composant (201) qui peut fonctionner comme multiplicateur de fréquence et comme mélangeur subharmonique, le signal d'entrée ($f_{LO}$) étant acheminé du premier composant au deuxième composant,

- le deuxième composant (201) comportant au moins un élément avec une courbe caractéristique non linéaire (203) à l'aide duquel peut être multipliée la fréquence d'un signal reçu du premier composant ;

- le premier composant (101) étant un mélangeur de transmission qui retransmet le signal d'entrée au deuxième composant et dispose d'une fonctionnalité de mélange aval dans le sens inverse dans lequel des signaux sont fournis par le deuxième composant ;

- le signal ($3f_{LO}$) multiplié en fréquence et fourni par le deuxième composant (201) étant émis via une antenne (301) ;

- un signal ($3f_{LO+doppler}$) étant reçu au moyen de l'antenne (301) et le signal reçu subissant un mélange subharmonique ($f_{LO+doppler}$) par le deuxième composant (201) et étant retransmis au premier composant (101) ;

- le signal retransmis du deuxième composant au premier composant subissant un mélange aval par le premier composant ;

- un signal de fréquence $f_3$ - $f_1$ étant fourni par le premier composant après le mélange aval,

f1 étant la fréquence ($f_{LO}$) du signal d'entrée resp. la fréquence ($f_{LO}$) du signal fourni au deuxième composant par le premier composant et

f3 étant la fréquence du signal qui a subi un mélange subharmonique par le deuxième composant et a été retransmis au premier composant.

6. Dispositif selon la revendication 5 destiné à être utilisé en lien avec des capteurs Doppler ou radar.

7. Dispositif selon l'une des revendications 5 ou 6, dans lequel l'élément avec la courbe caractéristique non linéaire (203) comprend deux diodes montées en antiparallèle.

8. Dispositif selon la revendication 7, dans lequel les diodes sont des diodes varicap ou des diodes Schottky.

9. Dispositif selon l'une des revendications 5 à 8, dans lequel le premier composant et/ou le deuxième composant sont réalisés selon la technologie des circuits imprimés, du film mince, du film épais ou sous la forme d'un circuit intégré.

10. Dispositif selon l'une des revendications 5 à 9, dans lequel le deuxième composant comporte au moins un filtre, et plus particulièrement au moins un filtre passe-haut et au moins un filtre passe-bas.

11. Dispositif selon la revendication 10, dans lequel l'au moins un élément non linéaire (203) du deuxième composant (201) est relié au premier composant (101) via le filtre passe-bas (202) et dans lequel l'au moins un élément non linéaire (203) est relié directement ou indirectement à une antenne (301) via le filtre passe-haut (204).

EP 2 603 972 B1

**Fig.1**

**Fig.2**

Fig.3

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4749949 A
- US 3076133 A
- US 20030094976 A1
- DE 102004048994 A1
- US 5495255 A
- US 5924021 A